**Europäisches Patentamt**

**European Patent Office**

**Office européen des brevets**

(19)

(11) Veröffentlichungsnummer: **0 140 091**
**A2**

(12) # EUROPÄISCHE PATENTANMELDUNG

(21) Anmeldenummer: **84110857.4**

(22) Anmeldetag: **12.09.84**

(51) Int. Cl.⁴: **H 03 G 3/20**
**H 04 B 9/00**

(30) Priorität: **04.10.83 DE 3336027**

(43) Veröffentlichungstag der Anmeldung:
**08.05.85 Patentblatt 85/19**

(84) Benannte Vertragsstaaten:
**DE FR GB**

(71) Anmelder: **ROBERT BOSCH GMBH**
**Postfach 50**
**D-7000 Stuttgart 1(DE)**

(72) Erfinder: **Ciulin, Dan**
**Chemin des Ecureuils 8**
**CH-1009 Pully(CH)**

(54) **Optoelektronischer Empfänger.**

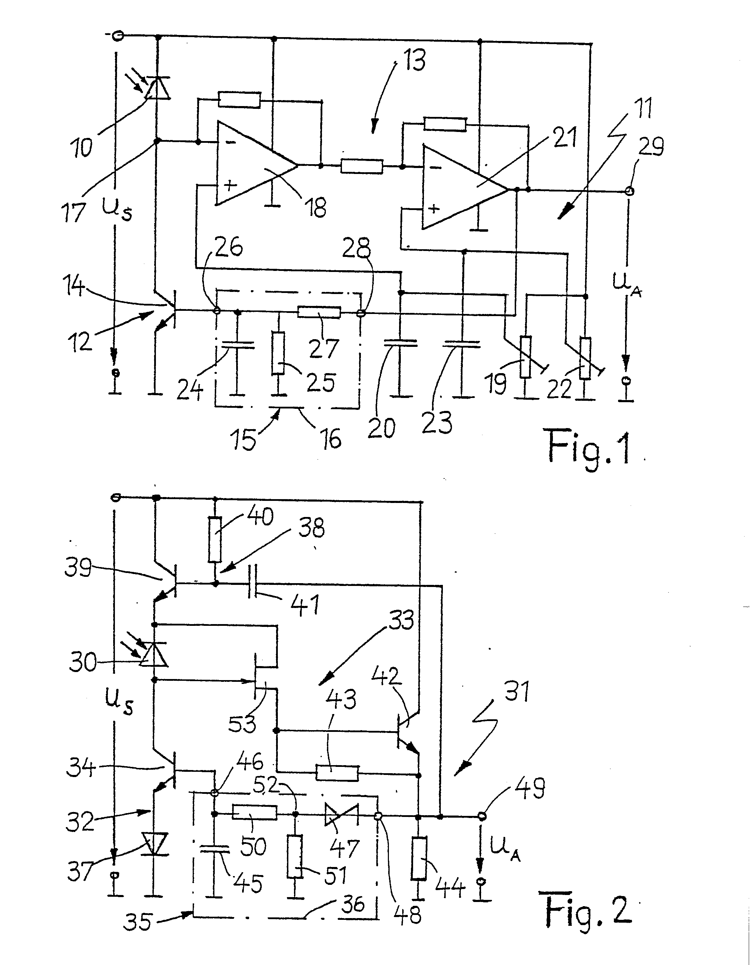

(57) Es wird ein optoelektronischer Empfänger mit einer an einer Spannungsquelle ($U_S$) angeschlossenen Reihenschaltung aus einer Fotodiode (10) und einer Vorrichtung (11) zur Erzeugung einer dem Fotodiodenstrom proportionalen Ausgangsspannung ($U_A$) angegeben, bei welchem zum Zwecke der Kompensierung von Störlichteinfall die Vorrichtung (11) eine steuerbare Stromquelle (12) und ein die Stromquelle (12) in Abhängigkeit von Störlicht steuerndes Steuerglied (13) aufweist. Die Steuerung der Stromquelle (12) erfolgt in einer solchen Weise, daß eine vom Störlicht hervorgerufene Änderung des Fotodiodenstroms im wesentlichen keine Änderung der Ausgangsspannung ($U_A$) bewirkt (Fig. 1).

EP 0 140 091 A2

./...

Fig.1

R. **18990**
7.9.1983

ROBERT BOSCH GMBH, 7000 Stuttgart 1

Optoelektronischer Empfänger

Stand der Technik

Die Erfindung betrifft einen optoelektronischen Empfänger der im Oberbegriff des Anspruchs 1 angegebenen Gattung.

Bei einem bekannten Empfänger dieser Art ist die Vorrichtung zur Erzeugung einer dem Fotodiodenstrom proportionalen Ausgangsspannung als ohmscher Widerstand ausgebildet. Der an dem Widerstand auftretende Spannungsabfall bildet die Ausgangsspannung des Empfängers.

Das auf die Fotodiode auftreffende Nutz- oder Signallicht, das von einem optischen Sender, z.B. einer Leuchtdiode herrührt, ist üblicherweise amplitudenmoduliert (im einfachsten Fall durch Ein- und Ausschalten des Senders), wobei die Modulationsfrequenz meist sehr viel größer als 100 Hz, üblicherweise 1 kHz oder höher, ist. Am Ausgang der Fotodiode tritt ein Fotodiodenstrom auf mit einer Gleichstromkomponente, die dem Mittel- oder Gleichrichtwert der Modulationsamplitude des Nutzlichtes entspricht, und mit einer Wechselstromkomponente, deren Amplitude (Spitze - Spitze) der Modulationsamplitude entspricht. Nun trifft auf die Fotodiode nicht nur das vom Sender erzeugte Signal- oder Nutzlicht, sondern auch sogenanntes Parasitär- oder Störlicht, das von der Umgebung, z.B. der Sonne, von Glüh- lampen, Leuchtstoffröhren, etc., herrührt. Sonnen- licht kann über ein ausreichend großes Zeitintervall als unmoduliertes Licht angesehen werden. Im Gegensatz hierzu weist das Licht einer Glühlampe eine Modulationsfrequenz von 100 Hz und auch 50 Hz auf.

Trifft nun zusätzlich solches Parasitärlicht auf die Fotodiode, so tritt im Falle der Sonnenlichteinstrahlung eine weitere Gleichstromkomponente und im Falle von Glühlampenlichteinfall eine weitere Gleich- und Wechselstromkomponente am Ausgang der Fotodiode auf. Die dem Fotodiodenstrom proportionale Ausgangsspannung des optoelektronischen Empfängers steigt dadurch rasch an und erreicht die Speisespannung der Spannungsquelle. Die Fotodiode liegt nunmehr außerhalb ihres Wirkspannungsbereichs und arbeitet nicht mehr korrekt, d.h. ein Signallichteinfall in diesem sogenannten Sättigungszustand der Fotodiode wird nicht mehr detektiert.

Zur Vermeidung dieser Sättigung der Fotodiode durch Parasitärlicht wurde bereits vorgeschlagen, die von der Spannungsquelle gelieferte Versorgungsspannung so hoch wie möglich zu machen, also geringfügig unterhalb der Durchbruchspannung der Fotodiode anzusiedeln, so daß die Fotodiode erst bei extrem hohem Störlichteinfall in die Sättigung gelangt. Hierzu werden jedoch Spannungsquellen mit sehr hoher Speisespannung benötigt, die relativ teuer sind. Im Falle des Batteriebetriebs des Empfängers müssen teure DC/DC-Konverter vorgesehen werden.

Es ist auch schon vorgeschlagen worden, anstelle der Vergrößerung der Speisespannung den Widerstandswert des ohmschen Widerstandes sehr klein zu machen, so daß ebenfalls erst ein extrem hoher Störlichteinfall die Sättigung der Fotodiode herbeiführen kann. Mit einem solch niedrigen Widerstand wird aber die Empfindlichkeit des optoelektronischen Empfängers extrem herabgesetzt und außerdem ein sehr schlechtes S/N-Verhältnis erzielt.

Vorteile der Erfindung

Der erfindungsgemäße optoelektronische Empfänger mit den kennzeichnenden Merkmalen des Anspruchs 1 hat demgegenüber den Vorteil, daß der beschriebene Sättigungseffekt der Fotodiode durch Störlichteinfall vermieden wird, wobei weder eine Spannungsquelle mit hoher Speisespannung erforderlich ist noch ein verschlechtertes Nutz-Stör-Verhältnis (Signal-Noise-Ratio) in Kauf zu nehmen ist.

Die steuerbare Stromquelle stellt einerseits für jede Frequenz des Nutz- oder Signallichts einen konstanten, sehr hohen Widerstand dar, so daß eine große Ausgangsspannung erzeugt und ein sehr gutes S/N-Verhältnis erzielt wird. Die steuerbare Stromquelle stellt aber andererseits für jede Frequenz des Parasitär- oder Störlichts einen variablen, sehr kleinen Widerstand dar, so daß die vom Parasitärlicht hervorgerufenen Stromkomponenten im Fotodiodenstrom keinen oder keinen nennenswerten Beitrag zur Ausgangsspannung liefern. Im letzten Fall wird praktisch der von der Stromquelle gelieferte Strom, der die Ausgangsspannung des optoelektronischen Empfängers bestimmt, so gesteuert, daß an der Fotodiode im wesentlichen immer der gleiche Spannungsabfall auftritt, so daß die Fotodiode nicht in ihren Sättigungszustand gelangen kann.

Ausführungsformen mit vorteilhaften Ausgestaltungen und Weiterbildungen der Erfindung ergeben sich aus den weiteren Ansprüchen.

Zeichnung

Die Erfindung ist anhand von in der Zeichnung darge-stellten Ausführungsbeispielen in der nachfolgenden Beschreibung näher erläutert.

Es zeigen:

Fig.1 jeweils einen Schaltplan eines opto-
und 2 elektronischen Empfängers gemäß einem
ersten und zweiten Ausführungsbeispiel.

Beschreibung der Ausführungsbeispiele

Die in Fig. 1 und 2 dargestellten optoelektronischen Empfänger weisen jeweils eine Reihenschaltung aus einer Fotodiode 10 bzw. 30, die jeweils einenvom Licht-

- 5 -

einfall abhängigen Fotodiodenstrom erzeugt, und aus
einer Vorrichtung 11 bzw. 31 zur Erzeugung einer dem
Fotodiodenstrom proportionalen Ausgangsspannung $U_A$
auf. Diese Reihenschaltung ist jeweils an eine Versorgungs-Gleichspannungsquelle angeschlossen, die
durch den Spannungspfeil $U_S$ symbolisch in Fig. 1
und 2 gekennzeichnet ist.

In beiden Empfängern weist die Vorrichtung 11 bzw. 31
eine steuerbare Stromquelle 12 bzw. 32 und ein Steuerglied 13 bzw. 33 auf, das die Stromquelle 12 bzw. 32
in Abhängigkeit von auf die Fotodiode 10 gelangendem
Parasitärlicht derart steuert, daß eine vom Parasitärlicht hervorgerufene Zunahme des Fotodiodenstroms
keine nennenswerte Vergrößerung der Ausgangsspannung
$U_A$ bewirkt. Hingegen blockiert das Steuerglied 13 bzw. 33
bei Einfall von Signal- oder Nutzlicht eine Änderung
des Steuerstroms für die Stromquelle 12 bzw. 32, so
daß die Zunahme des Fotodiodenstroms eine Vergrößerung
der Ausgangsspannung $U_A$ bewirkt.

In beiden optoelektronischen Empfängern weist hierzu
die steuerbare Stromquelle 12 bzw. 32 einen Transistor 14 bzw. 34, dessen Kollektor jeweils mit der
Anode der Fotodiode 10 bzw. 30 verbunden ist, und
das Steuerglied ein Filter 15 bzw. 35 auf, das der
Basis des Transistors 14 bzw. 34 vorgeschaltet ist.
Das Filter 15 bzw. 35, das in beiden Fällen als Tiefpaß 16 bzw. 36 mit einer Grenzfrequenz von ungefähr
100 Hz ausgebildet ist, läßt die vom Parasitär- oder
Störlicht herrührende Wechselkomponente im Fotodiodenstrom, deren Modulationsfrequenz kleiner als 100 Hz ist,
sowie die vom Parasitär- oder Störlicht herrührende
Gleichkomponente im Fotodiodenstrom als geeignet bemessener Steuerstrom an die Basis des Transistors 14 bzw. 34 gelangen, wo hingegen die vom Nutzlicht herrührende Wechselkomponente im Fotodiodenstrom von
der Basis ferngehalten wird.

Im einzelnen ist bei dem optoelektronischen Empfänger
gemäß Fig. 1 der Verbindungspunkt 17 zwischen der
Fotodiode 10 und dem Transistor 14 an dem invertierenden Eingang eines Operationsverstärkers 18 angeschlossen, dessen anderer Eingang mit einer Referenzspannung belegt ist. Die Referenzspannung
wird mittels eines Potentiometers 19 eingestellt,
dessen Spannungsabgriff ein Kondensator 20 parallel
geschaltet ist. Der Operationsverstärker 18 wirkt hier
als Strom-Spannungs-Konverter.

Am Ausgang des Operationsverstärkers 18 ist ein invertierender Spannungsverstärker oder Umkehrverstärker 21
angeschlossen. Die Referenzspannung für den Umkehrverstärker 21 wird ebenfalls von einem Potentiometer
22 abgenommen, das ebenso wie das Potentiometer 19
an der Versorgungs-Gleichspannungsquelle $U_S$ liegt
und dessen Potentialabgriff ebenfalls ein Kondensator 23 parallel geschaltet ist. Der Ausgang des
Umkehrverstärkers 21 ist über den Tiefpaß 16 an der
Basis des Transistors 14 angeschlossen. Der Tiefpaß 16
besteht hier in einfacher Weise aus einer Parallelschaltung eines Kondensators 24 und eines Widerstands
25, die einerseits unmittelbar mit dem Tiefpaßausgang 26 und andererseits über einen Widerstand 27
mit dem Tiefpaßeingang 28 verbunden ist. Der Ausgang des Umkehrverstärkers 21 ist weiterhin mit dem
Ausgang 29 des optoelektronischen Empfängers verbunden, an dem die vom Lichteinfall des Nutzlichtes abhängige Ausgangsspannung $U_A$ abnehmbar ist.

Durch die Rückkopplung des Fotodiodenstroms als Steuerstrom auf die Basis des Transistors 14 führen Wechselkomponenten im Fotodiodenstrom mit einer Frequenz kleiner als 100 Hz oder Gleichstromkomponenten zu einer Aufsteuerung des Transistors 14, so daß eine momentane Zunahme der Differenzspannung am Eingang des Operationsverstärkers 18 infolge des erhöhten Lichteinfalls und des dadurch vermehrten Fotodiodenstroms wieder ausgeregelt wird. Die Ausgangsspannung $U_A$ ändert sich dabei nicht. Dies trifft für Parasitär- oder Störlicht zu, dessen Modulationsfrequenz gleich oder kleiner als 100 Hz ist (Glühlampe, Leuchtstoffröhre) oder das unmoduliert ist (Sonnenlicht). Wechselkomponenten im Fotodiodenstrom mit einer Frequenz größer als 100 Hz gelangen infolge des Tiefpasses 16 nicht als Steuerstrom an den Transistor 14. Diese Wechselstromkomponenten führen daher zu einer entsprechenden Erhöhung der Ausgangsspannung des Umkehrverstärkers 21 und damit zu einer entsprechenden Vergrößerung der Ausgangsspannung $U_A$ des optoelektronischen Empfängers. Dieser Fall trifft für Nutz- oder Signallicht zu, dessen Modulationsfrequenz in der Regel etwa bei 1 kHz oder höher liegt.

Bei dem optoelektronischen Empfänger gemäß Fig. 2 ist dem Emitter des Transistors 34 eine Diode 37 nachgeschaltet und der Reihenschaltung aus Fotodiode 30, Transistor 34 und Diode 37 ein Bootstrap-Glied 38 vorgeschaltet. Das Bootstrap-Glied 38 weist einen Transistor 39 in Kollektorschaltung, auch Emitterfolger genannt, auf, dessen Basis einerseits über einen Widerstand 40 mit dem Pluspol der Versorgungs-Gleichspannungsquelle $U_S$ und über einen Kondensator 41 mit dem Ausgang 49 des optoelektronischen Empfängers verbunden ist. Das Bootstrap-Glied 38 ist derart ausgebildet, daß es die Ruhepunkt-Gleichspannung an der Kollektor-Emitter-Strecke des Transistors 39 konstant auf etwa 0,8 V hält.

Der Fotodiode 30 ist die Drain-Gate-Strecke eines Feldeffekttransistors (FET) 53 parallel geschaltet, dessen Source einerseits mit der Basis eines weiteren Transistors 42 in Kollektorschaltung und andererseits über einen Widerstand 43 mit dem Emitter des Transistors 42 verbunden ist. Der Kollektor des Transistors 42 ist wiederum an der Versorgungs-Gleichspannungsquelle $U_S$ angeschlossen. An dem Emitterwiderstand 44 ist über den Tiefpaß 36 die Basis des Transistors 34 angeschlossen. Außerdem ist der Emitterwiderstand 44 mit dem Ausgang 49 des optoelektronischen Empfängers verbunden.

Der Tiefpaß 36 weist hier eine Parallelschaltung aus einem Kondensator 45 und einer Reihenschaltung zweier Widerstände 50, 51 auf. Die Parallelschaltung ist unmittelbar mit dem Tiefpaßausgang 46 verbunden, während der Tiefpaßeingang 48 über eine Zenerdiode 47 an dem Verbindungspunkt 52 zwischen den beiden Widerständen 50, 51 angeschlossen ist.

Die Wirkungsweise des optoelektronischen Empfängers bezüglich der Trennung von Parasitär- und Nutzlicht ist die gleiche, wie die des zu Fig. 1 beschriebenen optoelektronischen Empfängers. Auch hier wird durch die Rückführung das vom Parasitärlicht herrührende Parasitär- oder Störsignal weitgehend kompensiert, so daß die Fotodiode 30 durch Störlichteinfall nicht in ihren Sättigungsbereich gelangen kann.

Die Erfindung ist nicht auf die vorstehend beschriebenen Ausführungsbeispiele beschränkt. So muß das Filter nicht unbedingt als Tiefpaß ausgebildet sein, sondern kann auch ein Bandpaß oder Hochpaß sein in entsprechender Anpassung an die am Empfangsort herrschende Störlichtart. Es können auch Filter mit komplexen, nichtlinearen Funktionen vorgesehen werden. Der Tiefpaß mit einer Grenzfrequenz von ungefähr 100 Hz (3 dB Dämpfung) hat sich jedoch als guter Kompromiß für das meist vorherrschende Störlicht im Verhältnis zu dem üblicherweise verwendeten modulierten Signallicht erwiesen. Das einfache Tiefpaßfilter vermeidet auch Instabilitäten in der Rückführung, die bei höherwertigen Filtern auftreten und besonderer Korrekturmaßnahmen bedürfen.

-.-.-.-.-.-.-

R. 18990

7.9.1983

ROBERT BOSCH GMBH, 7000 Stuttgart 1

Ansprüche

1. Optoelektronischer Empfänger mit einer an einer Spannungsquelle angeschlossenen Reihenschaltung aus einer Fotodiode zur Erzeugung eines vom Lichteinfall abhängigen Fotodiodenstroms und einer Vorrichtung zur Erzeugung einer dem Fotodiodenstrom proportionalen Ausgangsspannung, d a d u r c h   g e k e n n z e i c h n e t, daß die Vorrichtung (11;31) eine steuerbare Stromquelle (12;32) und ein die Stromquelle (12;32) in Abhängigkeit von Parasitärlicht steuerndes Steuerglied (13;33) aufweist  und daß die Steuerung der Stromquelle (12;32) in einer solchen Weise erfolgt, daß eine von Parasitärlicht hervorgerufene Änderung des Fotodiodenstroms im wesentlichen keine Änderung der Ausgangsspannung ($U_A$) bewirkt.

2. Empfänger nach Anspruch 1, d a d u r c h g e - k e n n z e i c h n e t, daß die Stromquelle (12;32) einen Transistor (14;34), dessen Kollektor-Emitter-Strecke in Reihe mit der Fotodiode (10;30) liegt, und das Steuerglied (13;33) ein der Basis des Transistors (14;34) vorgeschaltetes Filter (15;35) aufweist, dessen Durchlaßbereich auf die Frequenz der vom Parasitärlicht herrührenden Stromkomponente des Fotodiodenstroms und dessen Sperrbereich auf die Frequenz der vom Nutz- oder Signallicht herrührenden Stromkomponente abgestimmt ist.

3. Empfänger nach Anspruch 2, d a d u r c h g e - k e n n z e i c h n e t, daß der Kollektor des Transistors (14) mit der Fotodiode (10) verbunden und dieser Verbindungspunkt (17) an den invertierenden Eingang eines Operationsverstärkers (18) angeschlossen ist, dessen anderer Eingang mit einer einstellbaren Referenzspannung belegt ist, und daß dem Operationsverstärker (18) ein Umkehrverstärker (21) nachgeschaltet ist, an dessen Ausgang einerseits die Basis des Transistors (14) über das Filter (15) angeschlossen und andererseits die Ausgangsspannung ($U_A$) abnehmbar ist.

4. Empfänger nach Anspruch 2, d a d u r c h g e - k e n n z e i c h n e t, daß der Kollektor des Transistors (34) mit der Fotodiode (30) verbunden und dem Emitter eine Diode (37) nachgeschaltet ist, daß der Reihenschaltung aus Fotodiode (30), Transistor (34) und Diode (37) ein Bootstrap-Glied (38) vorgeschaltet ist, daß die Fotodiode (30) der Drain-Gate-Strecke eines Feldeffekttransistors (53) parallel geschaltet ist, dessen Source die Basis eines weiteren Transistors (42) in Kollektorschaltung steuert und daß an dem Emitterwiderstand (44) des weiteren Transistors (42) einerseits die Basis des ersten Transistors (34) über das Filter (36) angeschlossen und andererseits die Ausgangsspannung ($U_A$) abnehmbar ist.

5. Empfänger nach Anspruch 4, d a d u r c h  g e - k e n n z e i c h n e t, daß das Bootstrap-Glied (38) derart ausgebildet ist, daß der Spannungsabfall am Bootstrap-Glied (38) unabhängig von dem Fotodiodenstrom konstant etwa 0,8 V beträgt.

6. Empfänger nach einem der Ansprüche 2 - 5, d a - d u r c h  g e k e n n z e i c h n e t, daß das Filter (15;35) als Tiefpaß (16;36) mit einer Grenzfrequenz von ungefähr 100 Hz ausgebildet ist.

7. Empfänger nach Anspruch 3 und 6, d a d u r c h  g e k e n n z e i c h n e t, daß der Tiefpaß (16) eine Parallelschaltung von Kondensator (24) und Widerstand (25) aufweist, die an dem Tiefpaßausgang (26) unmittelbar und über einen weiteren Widerstand (27) an dem Tiefpaßeingang (28) angeschlossen ist.

8. Empfänger nach Anspruch 4 und 6, d a d u r c h  g e k e n n z e i c h n e t, daß der Tiefpaß (36) eine an dem Tiefpaßausgang (46) angeschlossene Parallelschaltung aus einem Kondensator (45) und einer Reihenschaltung zweier Widerstände (50,51) aufweist und daß der Tiefpaßeingang (48) über
eine Zenerdiode (47) an dem Verbindungspunkt
(52) der beiden Widerstände (50,51) angeschlossen ist.

–.–.–.–.–.–.–.–.–

Fig.1

Fig.2